# EUROPEAN PATENT APPLICATION

(11) **EP 1 427 267 A1**
(43) Date of publication of application: **09.06.2004**
(21) Application number: 02796283.6
(22) Date of filing: 21.08.2002
(51) Int. Cl.: H05K 3/46, H02B 1/48

(54) **MULTI-MILLING METHOD FOR THE PRODUCTION OF PRINTED CIRCUITS AND THE PRINTED CIRCUITS THUS OBTAINED**

(30) Priority: 24.08.2001 ES 200101962
(71) Applicant: Lear Automotive (EEDS) Spain, S.L., 43800 Valls, Tarragona (ES)
(72) Inventor: PINANA LOPEZ, Ramon, 43800 Valls (Tarragona) (ES)
(74) Representative: Primo de Rivera y Urquijo, Jose Antonio
(86) International application number: PCT/ES2002/000410
(87) International publication number: WO 2003/020001

(57) **Abstract**

A multiple-milling process for manufacturing printed circuits and the printed circuit thus obtained, constituted by a process for preparing the substrate of the printed circuit boards (1) for the production of bending areas (2) from whence to bend said printed circuits (1). This process consists of a multiple-milling system, by means of a mill (3) with special features, comprising a roll provided with multiple polishing strips on its surface, capable of making an undercutting in parallel strips (4) in said bending areas (2) of a printed circuit (1), allowing for their subsequent bending without deteriorating the metallic material conductive tracks adhered to the printed board's substrate on the side opposite the milled surface.

## Description

### OBJECT OF THE INVENTION

The present invention, a multiple-milling process for manufacturing printed circuits and the printed circuit thus obtained, consists of a production system of printed circuits used in the electronics industry, which comprises bending a printed circuit of a given thickness, achieving the increase in versatility thereof, especially in applications that require high space usage efficiency.

It is thus that the present invention will be of special interest for the electronics industry sector in general and, in particular, for manufacturers of printed circuits with special features.

### DESCRIPTION OF THE STATE OF THE ART

Virtually all electronic circuits existing in equipment commercialized in the market nowadays are carried out by means of printed circuits where the various components placed and soldered are placed or located on the corresponding tracks. Said printed circuits comprise a base board or substrate over which tracks made of conductive materials, usually copper, are incorporated by means of adhesive processes. The bonding between different electronic components, semiconductors, resistors, capacitors, coils, etc., is carried out by means of perforations on the base board, through which the components' terminals penetrate in order to be soldered to the track's surface by means of conductive alloys, usually of tin. Said board can have a double circuit, in the case where both sides thereof are provided with tracks of the conductive material, copper.

In order to carry out circuits of greater complexity, it is necessary to stack or use diverse printed circuits, spatially located on different planes, being necessary in many cases to bend the circuits' base board in order for them to adapt to the service boxes, which, in turn, are externally designed to adapt to the configuration of the automobile's wall or surface.

Spanish Patent P9700225, filed by the same holder, discloses improvements in the manufacture of printed circuits consisting of the substitution of the rigid dielectric material used up to that time for a flexible material that allows bending of the boards in addition to facilitating the adhesion of the conductive copper layer and preventing the conductive copper layer from delaminating from the resilient support.

Patent P9200325, from the same applicant, discloses different possibilities for board bending, including the possibility of 180º bending by milling only one longitudinal strip on the insulating support, which allows bending conductive boards at least 400 microns thick.

The previous bending processes have the drawback that the conductive copper portion must have a thickness of at least 400 microns to prevent it from breaking when bent. By means of the present, multiple-milling process for manufacturing printed circuits whose conductive board has a thickness of less than 400 microns, a treatment applied to the circuits' base board is achieved which allows performing one or multiple bends (up to 180º), with a progressive character, such that the metallic tracks are left undamaged and no breaking whatsoever of the conductive board occurs after milling of the support substrate.

As a result of this, there is a drawback in the current state of the art preventing the application of these techniques to manufacturing bent conductive boards whose thickness is less than 400 microns.

### DESCRIPTION

The present, multiple-milling process is comprised of a system for preparing the printed circuit board substrate, for the production of bending areas from whence to bend said printed circuits. This process consists of a multiple-milling system by means of a mill of special features, comprised of a roll provided with many polishing strips on its surface, capable of carrying out an undercutting in several parallel strips in said bending area of a printed circuit, allowing for subsequent bending thereof without deterioration of the metallic material, conductive tracks, adhered to the printed circuit substrate on the side opposite the milled side.

The present process allows bending not only printed power circuits with conductive layers of large thicknesses (400 microns), but also printed signal circuits whose thicknesses are lesser due to the lower intensity flowing through them. This way, it is possible to bend printed signal circuits without using more than the necessary conductive material, which implies the subsequent savings in material.

The printed circuit obtained by following the previously disclosed process consists of a bent circuit with at least a conductive portion adhered to the insulating or support substrate.

### DESCRIPTION OF THE DRAWINGS

In order to facilitate the comprehension of the multiple-milling process, three drawings are attached to the present patent application whose objective is the better comprehension of the principles on which the invention at hand is based and the better understanding of the description of a preferred embodiment form, taking into account that the character of the figures is illustrative and non-limiting.

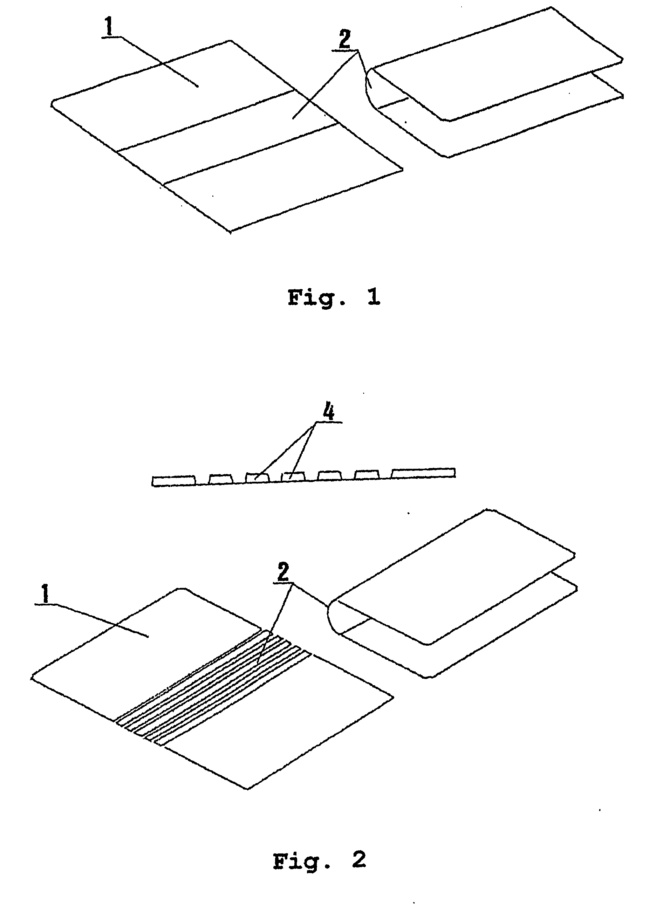

Figure 1 shows a perspective view of the bending system, by means of just one milling, for printed circuit boards with a conductive copper layer with a thickness of 400 microns.

Figure 2 shows a perspective view of a printed circuit produced by means of the present, multiple-milling process for printed circuit boards with a conductive copper layer and a thickness of 105 microns.

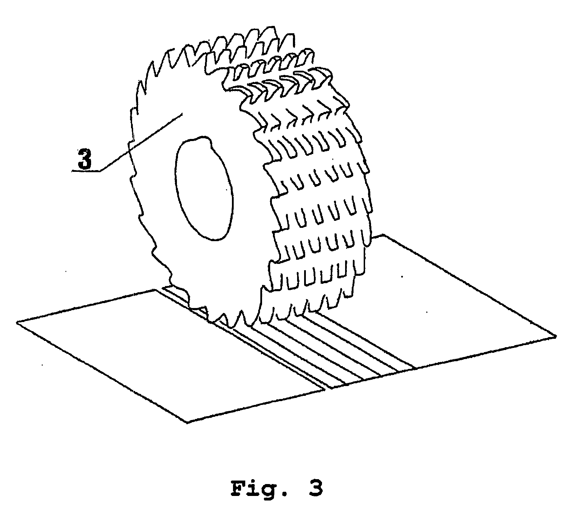

Figure 3 shows a perspective view of the prior printed circuit during the multiple-milling phase.

### DESCRIPTION OF A PREFERRED EMBODIMENT FORM

The multiple-milling process for manufacturing printed circuits shown in this preferred embodiment form is basically constituted by a process for preparing the board substrate of the printed circuits 1 for the production of bending areas 2 from whence to bend the copper layer of said printed circuits 1. The conductive layer has a thickness of 105 microns, although it can vary between 65 and 400 microns.

This process consists of a multiple-milling system, by means of a mill 3 with special features, comprised of a roll provided with a multitude of polishing strips or teeth on the surface thereof, capable of performing an undercutting in the shape of parallel strips 4 in said bending areas 2 of a printed circuit 1, allowing for its subsequent bending without deteriorating the conductive copper tracks adhered to the printed circuit's substrate on the side opposite the milled surface.

The mill 3 acts on the conductive copper layer's support substrate 1 by removing material in multiple parallel strips 4 until the final substrate thickness which allows for bending the 105 micron, conductive copper layer up to 180º is reached, preventing its breakage.

Within its essentiality, the invention can be carried out in practice in other embodiment forms differing only in details to the one indicated solely by way of example. This may be carried out in any shape and size, with the most suitable means and materials and with the most suitable accessories, it being possible to substitute the component elements for other, technically equivalent components, as all is contained within the claims.

## Claims

1. A multiple-milling process for manufacturing printed circuits, constituted by a process for preparing the substrate of printed circuit boards (1) for the production of bending areas (2) from whence to bend such printed circuits (1), **characterized by** consisting of performing the undercutting in multiple parallel strips on the printed circuit's support substrate by means of a milling tool (3) allowing for the subsequent bending of the printed circuit up to a value of 180º without deteriorating the metallic material conductive tracks adhered to the printed circuit substrate on the side opposite the milled surface.

2. A multiple-milling process for manufacturing printed circuits according to claim 1, **characterized in that** the milling tool is a mill comprising a roll provided with multiple polishing strips or teeth on its surface.

3. A printed circuit obtained according to the process disclosed in claims 1 and 2, **characterized in that** the conductive layer's thickness ranges between 65 and 400 microns.

4. A printed circuit obtained according to the process disclosed in claims 1 and 2, **characterized in that** the thickness conductive layer is 105 microns.

5. A printed circuit obtained according to the process disclosed in claims 1 and 2, **characterized in that** the conductive layer's material is copper.
